# EUROPEAN PATENT APPLICATION

(11) **EP 4 585 581 A1**
(43) Date of publication of application: **16.07.2025**
(21) Application number: 23863276.4
(22) Date of filing: 08.09.2023
(51) Int. Cl.: C04B 37/02, H01L 23/15, H05K 1/03

(54) **COPPER/CERAMIC BONDED BODY AND INSULATED CIRCUIT BOARD**

(30) Priority: 09.09.2022 JP 2022143902; 31.05.2023 JP 2023089701; 30.06.2023 JP 2023108414
(71) Applicant: Mitsubishi Materials Corporation, Tokyo 100-8117 (JP)
(72) Inventor: TERASAKI, Nobuyuki, Saitama-shi, Saitama 330-8508 (JP)
(74) Representative: Hoffmann Eitle
(86) International application number: PCT/JP2023/032886
(87) International publication number: WO 2024/053738

(57) **Abstract**

A copper/ceramic bonded body (10, 110) in which a copper member (12, 13, 112, 113) consisting of copper or a copper alloy and a ceramic member (11, 111) are bonded to each other, in which an active metal compound layer (31) containing a compound of one or more active metals selected from the group consisting of Ti, Zr, Nb, and Hf, or a magnesium oxide layer (131) is formed in a region of the ceramic member (11, 111) on a copper member side, and a transition metal layer (34, 134) containing one or more transition metals selected from the group consisting of V, Cr, Mn, Fe, Co, Ni, Mo, Ta, and W is formed in an interface of the active metal compound layer (31) or the magnesium oxide layer (131) on the copper member side.

## Description

### TECHNICAL FIELD

The present invention relates to a copper/ceramic bonded body obtained by bonding a copper member consisting of copper or a copper alloy and a ceramic member to each other, and an insulated circuit board obtained by bonding a copper sheet consisting of copper or a copper alloy to a surface of a ceramic substrate.

The present application claims priority on Japanese Patent Application No. 2022-143902 filed on September 9, 2022, Japanese Patent Application No. 2023-089701 filed on May 31, 2023 and Japanese Patent Application No. 2023-108414 filed on June 30, 2023, the contents of which are incorporated herein by reference.

### BACKGROUND ART

A power module, an LED module, and a thermoelectric module have a structure in which a power semiconductor element, an LED element, or a thermoelectric element is bonded to an insulated circuit board, and in the insulated circuit board, a circuit layer consisting of a conductive material is formed on one surface of an insulating layer.

For example, a power semiconductor element for high power control, which is used for controlling a wind power generation, an electric vehicle, a hybrid vehicle, or the like, generates a large amount of heat during operation, and thus, an insulated circuit board including a ceramic substrate, a circuit layer formed by bonding a metal sheet having excellent conductive properties to one surface of the ceramic substrate, and a metal layer for heat radiation, which is formed by bonding a metal sheet to the other surface of the ceramic substrate has been widely used in the related art as a substrate on which the power semiconductor element is mounted.

For example, Patent Document 1 proposes an insulated circuit board in which a circuit layer and a metal layer are formed by bonding a copper sheet to each of one surface and the other surface of a ceramic substrate. In Patent Document 1, the copper sheet is disposed on each of the one surface and the other surface of the ceramic substrate with an Ag-Cu-Ti-based brazing material being interposed, and then a heat treatment is carried out to bond the copper sheet (so-called active metal brazing method). In this active metal brazing method, since a brazing material containing Ti, which is an active metal, is used, wettability between the molten brazing material and the ceramic substrate is improved, and the ceramic substrate and the copper sheet are satisfactorily bonded to each other.

### Citation List

### Patent Document

Patent Document 1: Japanese Patent No. 3211856

### SUMMARY OF INVENTION

### Technical Problem

In recent years, there is a tendency that a heat generation temperature of a semiconductor element mounted on an insulated circuit board increases. In addition, in a semiconductor device in which a semiconductor element is mounted on an insulated circuit board, the semiconductor element is used as a high-temperature operating device capable of high-speed switching.

Therefore, the insulated circuit board is subjected to thermal stress under a high temperature condition in a short period, and thus higher thermal cycle reliability is required than in the related art.

The present invention has been made in consideration of the above-described circumstances, and an objective of the present invention is to provide a copper/ceramic bonded body having an excellent bonding rate between a ceramic member and a copper member and an excellent thermal cycle reliability even in a case where a severe thermal cycle is loaded, and an insulated circuit board consisting of the copper/ceramic bonded body.

### Solution to Problem

In order to solve the above-described problem, a copper/ceramic bonded body of an aspect 1 of the present invention is a copper/ceramic bonded body in which a copper member consisting of copper or a copper alloy and a ceramic member are bonded to each other, in which an active metal compound layer containing a compound of one or more active metals selected from the group consisting of Ti, Zr, Nb, and Hf, or a magnesium oxide layer is formed in a region of the ceramic member on a copper member side, and a transition metal layer containing one or more transition metals selected from the group consisting of V, Cr, Mn, Fe, Co, Ni, Mo, Ta, and W is formed in an interface of the active metal compound layer or the magnesium oxide layer on the copper member side.

In the copper/ceramic bonded body according to the aspect 1 of the present invention, a Mg solid solution layer may be formed in a region of the copper member on a ceramic member side, and the transition metal layer may be formed between the Mg solid solution layer and either one of the active metal compound layer or the magnesium oxide layer.

In the copper/ceramic bonded body of the aspect 1 of the present invention, the active metal compound layer or the magnesium oxide layer is formed in the region of the ceramic member on the copper member side, the Mg solid solution layer is formed in the region of the copper member on the ceramic member side, and the transition metal layer is formed between the Mg solid solution layer and either one of the active metal compound layer or the magnesium oxide layer.

Since the active metal compound layer or the magnesium oxide layer and the Mg solid solution layer and the transition metal layer have high bonding rate, and the transition metal layer has higher bonding rate with copper than the active metal compound layer or the magnesium oxide layer, the Mg solid solution layer is formed in the region of the copper member on the ceramic member side, and the transition metal layer is present between the Mg solid solution layer and either one of the active metal compound layer or the magnesium oxide layer; and thereby, the bonding reliability between the ceramic member and the copper member is significantly improved.

Therefore, in the copper/ceramic bonded body according to the aspect 1 of the present invention, even in a case where a thermal cycle under a high temperature condition is loaded with a short period, the ceramic member and the copper member are not peeled off from each other, and the thermal cycle reliability is particularly excellent.

The copper/ceramic bonded body according to an aspect 2 of the present invention is the copper/ceramic bonded body according to the aspect 1, in which the active metal compound layer has a structure in which a plurality of active metal compound particles are aggregated.

The copper/ceramic bonded body according to an aspect 3 of the present invention is the copper/ceramic bonded body according to the aspect 2, in which a copper grain boundary phase is present between the active metal compound particles.

The copper/ceramic bonded body according to an aspect 4 of the present invention is the copper/ceramic bonded body according to the aspect 1, in which the magnesium oxide layer has a structure in which a plurality of magnesium oxide particles are aggregated.

The copper/ceramic bonded body according to an aspect 5 of the present invention is the copper/ceramic bonded body according to the aspect 4, in which a copper grain boundary phase is present between the magnesium oxide particles.

An insulated circuit board according to an aspect 6 of the present invention is an insulated circuit board in which a copper sheet consisting of copper or a copper alloy is bonded to a surface of a ceramic substrate, in which an active metal compound layer containing a compound of one or more active metals selected from the group consisting of Ti, Zr, Nb, and Hf, or a magnesium oxide layer is formed in a region of the ceramic substrate on a copper sheet side, a Mg solid solution layer is formed in a region of the copper sheet on a ceramic substrate side, and a transition metal layer containing one or more transition metals selected from the group consisting of V, Cr, Mn, Fe, Co, Ni, Mo, Ta, and W is formed between the Mg solid solution layer and either one of the active metal compound layer or the magnesium oxide layer.

In the insulated circuit board of the aspect 6 of the present invention, the active metal compound layer or the magnesium oxide layer is formed in the region of the ceramic substrate on the copper sheet side, the Mg solid solution layer is formed in the region of the copper sheet on the ceramic substrate side, and the transition metal layer is formed between the Mg solid solution layer and either one of the active metal compound layer or the magnesium oxide layer; and thereby, bonding reliability between the ceramic substrate and the copper sheet is significantly improved.

Therefore, in the insulated circuit board according to the aspect 6 of the present invention, even in a case where a thermal cycle under a high temperature condition is loaded with a short period, the ceramic substrate and the copper sheet are not peeled off from each other, and the thermal cycle reliability is particularly excellent.

The insulated circuit board according to an aspect 7 of the present invention is the insulated circuit board according to the aspect 6, in which the active metal compound layer has a structure in which a plurality of active metal compound particles are aggregated.

The insulated circuit board according to an aspect 8 of the present invention is the insulated circuit board according to the aspect 7, in which a copper grain boundary phase is present between the active metal compound particles.

The insulated circuit board according to an aspect 9 of the present invention is the insulated circuit board according to the aspect 6, in which the magnesium oxide layer has a structure in which a plurality of magnesium oxide particles are aggregated.

The insulated circuit board according to an aspect 10 of the present invention is the insulated circuit board according to the aspect 9, in which a copper grain boundary phase is present between the magnesium oxide particles.

A copper/ceramic bonded body of an aspect 11 of the present invention is a copper/ceramic bonded body in which a copper member consisting of copper or a copper alloy and a ceramic member are bonded to each other, in which an active metal compound layer containing a compound of one or more active metals selected from the group consisting of Ti, Zr, Nb, and Hf is formed in a region of the ceramic member on a copper member side, and a transition metal layer containing one or more transition metals selected from the group consisting of V, Cr, Mn, Fe, Co, Ni, Mo, Ta, and W is formed in an interface of the active metal compound layer on the copper member side.

In the copper/ceramic bonded body according to the aspect 11 of the present invention, the active metal compound layer is formed in the region of the ceramic member on the copper member side, and the transition metal layer is formed in the interface of the active metal compound layer on the copper member side. Since the active metal compound layer and the transition metal layer have high coordination, and the transition metal layer has higher coordination with copper than the active metal compound layer, the active metal compound layer is formed in the region of the ceramic member on the copper member side, and the transition metal layer is present between the active metal compound layer and the copper member; and thereby, the bonding reliability between the ceramic member and the copper member is significantly improved.

Therefore, in the copper/ceramic bonded body according to the aspect 11 of the present invention, even in a case where a thermal cycle under a high temperature condition is loaded with a short period, the ceramic member and the copper member are not peeled off from each other, and the thermal cycle reliability is particularly excellent.

The copper/ceramic bonded body according to an aspect 12 of the present invention is the copper/ceramic bonded body according to the aspect 11, in which the transition metal layer contains one or more transition metals selected from the group consisting of V, Cr, Mn, Fe, Co, and Ni.

According to the copper/ceramic bonded body of the aspect 12 of the present invention, since the transition metal layer contains one or more transition metals selected from the group consisting of V, Cr, Mn, Fe, Co, and Ni; and thereby, the bonding reliability between the ceramic member and the copper member is reliably improved.

The copper/ceramic bonded body according to an aspect 13 of the present invention is the copper/ceramic bonded body according to the aspect 11 or the aspect 12, in which a Cu-Ag layer containing a Cu phase and an Ag phase is formed in a region of the copper member on the ceramic member side, and the transition metal layer is formed between the Cu phase and the active metal compound layer and between the Ag phase and the active metal compound layer.

According to the copper/ceramic bonded body according to the aspect 13 of the present invention, the coordination between the transition metal layer and both of the Cu phase and the Ag phase is high, and even in a case where the Cu-Ag layer including the Cu phase and the Ag phase is formed in the region of the copper member on the ceramic member side, the bonding reliability between the ceramic member and the copper member is significantly improved.

An insulated circuit board of an aspect 14 of the present invention is an insulated circuit board in which a copper sheet consisting of copper or a copper alloy is bonded to a surface of a ceramic substrate, in which an active metal compound layer containing a compound of one or more active metals selected from the group consisting of Ti, Zr, Nb, and Hf is formed in a region of the ceramic substrate on a copper sheet side, and a transition metal layer containing one or more transition metals selected from the group consisting of V, Cr, Mn, Fe, Co, Ni, Mo, Ta, and W is formed in an interface of the active metal compound layer on the copper sheet side.

In the insulated circuit board according to the aspect 14 of the present invention, the active metal compound layer is formed in the region of the ceramic substrate on the copper sheet side, and the transition metal layer is formed in the interface of the active metal compound layer on the copper sheet side; and thereby, the bonding reliability between the ceramic substrate and the copper sheet is significantly improved.

Therefore, in the insulated circuit board according to the aspect 14 of the present invention, even in a case where a thermal cycle under a high temperature condition is loaded with a short period, the ceramic substrate and the copper sheet are not peeled off from each other, and the thermal cycle reliability is particularly excellent.

The insulated circuit board according to an aspect 15 of the present invention is the insulated circuit board according to the aspect 14, in which the transition metal layer contains one or more transition metals selected from the group consisting of V, Cr, Mn, Fe, Co, and Ni.

According to the insulated circuit board of the aspect 15 of the present invention, since the transition metal layer contains one or more transition metals selected from the group consisting of V, Cr, Mn, Fe, Co, and Ni; and thereby, the bonding reliability between the ceramic substrate and the copper sheet is reliably improved.

The insulated circuit board according to an aspect 16 of the present invention is the insulated circuit board according to the aspect 14 or the aspect 15, in which a Cu-Ag layer containing a Cu phase and an Ag phase is formed in a region of the copper sheet on the ceramic substrate side, and the transition metal layer is formed between the Cu phase and the active metal compound layer and between the Ag phase and the active metal compound layer.

According to the insulated circuit board according to the aspect 16 of the present invention, the coordination between the transition metal layer and both of the Cu phase and the Ag phase is high, and even in a case where the Cu-Ag layer including the Cu phase and the Ag phase is formed in the region of the copper sheet on the ceramic substrate side, the bonding reliability between the ceramic substrate and the copper sheet is significantly improved.

### Advantageous Effects of Invention

According to the present invention, it is possible to provide a copper/ceramic bonded body having an excellent bonding rate between a ceramic member and a copper member and excellent thermal cycle reliability, even in a case where a severe thermal cycle is loaded, and an insulated circuit board consisting of the copper/ceramic bonded body.

### BRIEF DESCRIPTION OF DRAWINGS

[FIG. 1] A schematic explanatory view of a power module using an insulated circuit board according to an embodiment of the present invention.
[FIG. 2] An enlarged explanatory view of a bonded interface between either one of a circuit layer or a metal layer and a ceramic substrate of an insulated circuit board according to a first embodiment of the present invention.
[FIG. 3] A flowchart of a method of manufacturing an insulated circuit board according to a first embodiment of the present invention.
[FIG. 4] A schematic explanatory view of a method of manufacturing an insulated circuit board according to a first embodiment of the present invention.
[FIG. 5] A schematic explanatory view of an insulated circuit board according to a second embodiment of the present invention.
[FIG. 6] An enlarged explanatory view of a bonded interface between either one of a circuit layer or a metal layer and a ceramic substrate of an insulated circuit board according to a second embodiment of the present invention.
[FIG. 7A] An explanatory view of a surface cutting test in examples.
[FIG. 7B] An explanatory view of a surface cutting test in examples.
[FIG. 8] A photomicrograph of a bonded interface of an insulated circuit board of Invention Example A1 in examples.
[FIG. 9] A photomicrograph of a bonded interface of an insulated circuit board of Invention Example A2 in examples.

### DESCRIPTION OF EMBODIMENTS

Hereinafter, embodiments of the present invention will be described with reference to the accompanying drawings.

### (First embodiment)

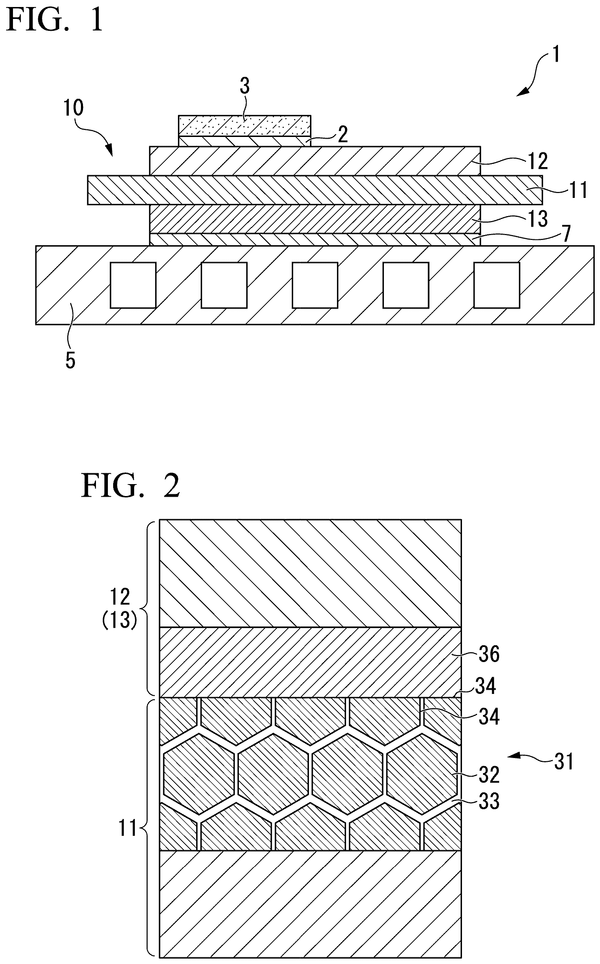

A copper/ceramic bonded body according to a first embodiment of the present invention is an insulated circuit board 10 obtained by bonding a ceramic substrate 11 as a ceramic member consisting of ceramics and both of a copper sheet 22 (a circuit layer 12) and a copper sheet 23 (a metal layer 13) as copper members consisting of copper or a copper alloy to each other. FIG. 1 shows a power module 1 including the insulated circuit board 10 according to the present embodiment.

The power module 1 includes the insulated circuit board 10 on which the circuit layer 12 and the metal layer 13 are arranged, a semiconductor element 3 bonded to one surface (the upper surface in FIG. 1) of the circuit layer 12 by interposing a bonding layer 2, and a heatsink 5 disposed on the other side (the lower side in FIG. 1) of the metal layer 13.

The semiconductor element 3 includes a semiconductor material such as Si. The semiconductor element 3 and the circuit layer 12 are bonded with the bonding layer 2 being interposed therebetween.

The bonding layer 2 is composed of, for example, an Sn-Ag-based solder material, an Sn-In-based solder material, or an Sn-Ag-Cu-based solder material.

The heatsink 5 is a heatsink for dissipating heat from the insulated circuit board 10 described above. The heatsink 5 is composed of copper or a copper alloy, and in the present embodiment, the heatsink 5 is composed of phosphorus deoxidized copper. The heatsink 5 includes a passage for allowing a cooling fluid to flow.

It is noted that in the present embodiment, the heatsink 5 is bonded to the metal layer 13 by a solder layer 7 which consists of a solder material. The solder layer 7 is composed of, for example, an Sn-Ag-based solder material, an Sn-In-based solder material, or an Sn-Ag-Cu-based solder material.

In addition, the insulated circuit board 10 according to the present embodiment includes, as shown in FIG. 1, the ceramic substrate 11, the circuit layer 12 arranged on one surface of the ceramic substrate 11 (the upper surface in FIG. 1), and the metal layer 13 arranged on the other surface of the ceramic substrate 11 (the lower surface in FIG. 1).

The ceramic substrate 11 is composed of ceramics such as silicon nitride (Si₃N₄), aluminum nitride (AlN), and alumina (Al₂O₃) having excellent insulating properties and heat radiation. In the present embodiment, the ceramic substrate 11 is composed of aluminum nitride (AlN) having particularly excellent heat radiation. In addition, a thickness of the ceramic substrate 11 is set to be, for example, in a range of 0.2 mm or more and 1.5 mm or less, and in the present embodiment, the thickness thereof is set to 0.635 mm.

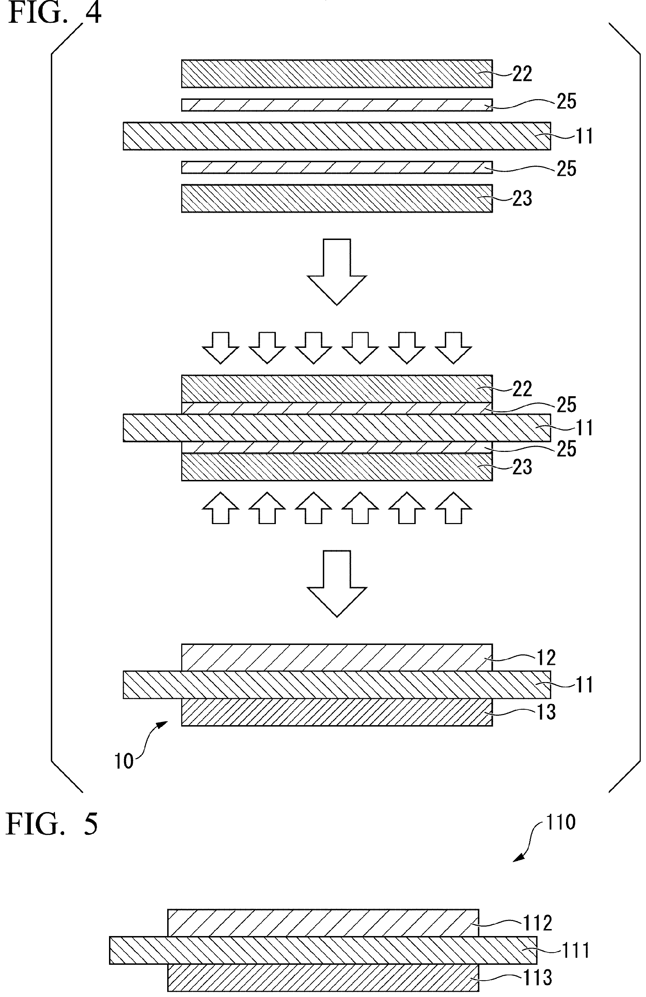

As shown in FIG. 4, the circuit layer 12 is formed by bonding the copper sheet 22 consisting of copper or a copper alloy to one surface (the upper surface in FIG. 4) of the ceramic substrate 11.

In the present embodiment, the circuit layer 12 is formed by bonding a rolled sheet of oxygen-free copper to the ceramic substrate 11.

It is noted that a thickness of the copper sheet 22 which is to be the circuit layer 12 is set to be in a range of 0.1 mm or more and 2.0 mm or less, and in the present embodiment, the thickness thereof is set to 0.25 mm.

As shown in FIG. 4, the metal layer 13 is formed by bonding the copper sheet 23 consisting of copper or a copper alloy to the other surface (the lower surface in FIG. 4) of the ceramic substrate 11.

In the present embodiment, the metal layer 13 is formed by bonding a rolled sheet of oxygen-free copper to the ceramic substrate 11.

It is noted that a thickness of the copper sheet 23 which is to be the metal layer 13 is set in a range of 0.1 mm or more and 2.0 mm or less, and in the present embodiment, the thickness thereof is set to 0.25 mm.

FIG. 2 shows an enlarged view of the vicinity of a bonded interface between the ceramic substrate 11 and the circuit layer 12 (metal layer 13).

An active metal compound layer 31 containing a compound of one or more active metals selected from the group consisting of Ti, Zr, Nb, and Hf is formed in a region of the ceramic substrate 11 on the circuit layer 12 (metal layer 13) side.

The active metal compound layer 31 is formed by diffusing an active metal (Ti, Zr, Nb, or Hf) used in a case of bonding the ceramic substrate 11 and the copper sheet 22 (copper sheet 23) to each other into the ceramic substrate 11 and reacting with constituent elements of the ceramic substrate 11, and is a part of the ceramic substrate 11.

More specifically, in a case where the ceramic substrate consists of silicon nitride (Si₃N₄) or aluminum nitride (AlN), the active metal compound layer 31 is a layer consisting of a nitride of these active metals. In a case where the ceramic substrate is alumina (Al₂O₃), a layer containing an oxide of these active metals is formed.

As shown in FIG. 2, the active metal compound layer 31 has a structure in which a plurality of active metal compound particles 32 are aggregated, and a copper grain boundary phase 33 is present between the active metal compound particles 32.

In the present embodiment, Ti is used as the active metal used for bonding, and the ceramic substrate 11 is composed of silicon nitride (Si₃N₄), so that the active metal compound layer 31 is mainly composed of titanium nitride (TiN).

In addition, in the present embodiment, the active metal compound layer 31 is formed by aggregating a plurality of titanium nitride particles (active metal compound particles 32) having an average particle size of 10 nm or more and 100 nm or less.

A transition metal layer 34 containing one or more transition metals selected from the group consisting of V, Cr, Mn, Fe, Co, Ni, Mo, Ta, and W is formed in an interface of the active metal compound layer 31 on the circuit layer 12 (metal layer 13) side.

The transition metal layer 34 may contain one or more transition metals selected from the group consisting of V, Cr, Mn, Fe, Co, and Ni.

The transition metal layer 34 may be formed not only at the interface of the active metal compound layer 31 on the circuit layer 12 (metal layer 13) side, but also at the interface between the active metal compound particles 32 and the copper grain boundary phase 33. That is, the transition metal layer 34 may be formed on an outer peripheral surface of the active metal compound particles 32 constituting the active metal compound layer 31.

In addition, in the present embodiment, a Mg solid solution layer 36 is formed in a region of the circuit layer 12 (metal layer 13) on the ceramic substrate 11 side.

The Mg solid solution layer 36 is formed by diffusing Mg contained in a bonding material used in a case of bonding the ceramic substrate 11 and the copper sheet 22 (copper sheet 23) to the copper sheet 22 (copper sheet 23) side, and is a part of the circuit layer 12 (metal layer 13).

A Cu-Ag layer including a Cu phase and an Ag phase may be formed in a region of the circuit layer 12 (metal layer 13) on the ceramic substrate 11 side, instead of the Mg solid solution layer 36 or in a form of overlapping with the Mg solid solution layer 36.

The Cu-Ag layer 36 is formed by diffusing Ag contained in a bonding material used in a case of bonding the ceramic substrate 11 and the copper sheet 22 (copper sheet 23) to the copper sheet 22 (copper sheet 23) side, and is a part of the circuit layer 12 (metal layer 13).

The Cu-Ag layer 36 includes a Cu phase and an Ag phase, and the transition metal layer 34 is formed between the Cu phase and the active metal compound layer 31 (active metal compound particles 32) and between the Ag phase and the active metal compound layer 31 (active metal compound particles 32).

The copper grain boundary phase 33 formed between the plurality of active metal compound particles 32 may contain Ag. In this case, the transition metal layer 34 may be formed between Cu of the copper grain boundary phase 33 and the active metal compound layer 31 (active metal compound particles 32) and between Ag of the copper grain boundary phase 33 and the active metal compound layer 31 (active metal compound particles 32).

In the Mg solid solution layer 36, a Mg concentration is set to be in a range of 0.05 at% or more and 6.9 at% or less with respect to 100 at% of a total amount of Cu, Mg, the active metal, and the transition metal.

In addition, the Mg solid solution layer 36 may contain an intermetallic compound (for example, Cu₂Mg, CuMg₂, and the like) in which the Mg concentration is in a range of 30 at% or more and 70 at% or less.

In the present embodiment, a thickness of the active metal compound layer 31 is preferably set to be in a range of 0.05 µm or more and 1.2 µm or less.

In addition, in the present embodiment, a thickness of the Mg solid solution layer 36 is preferably set to be in a range of more than 0 µm and 200 µm or less, and more preferably set to be in a range of 50 µm or more and 120 µm or less.

A thickness of the Cu-Ag layer 36 may be set to be in a range of 0 µm or more and 15 µm or less.

Furthermore, in the present embodiment, a thickness of the transition metal layer 34 is preferably set to be in a range of 1 nm or more and 15 nm or less.

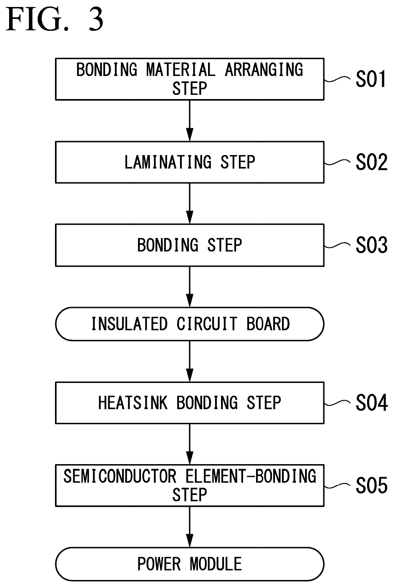

Hereinafter, a method of manufacturing the insulated circuit board 10 according to the present embodiment will be described with reference to FIGS. 3 and 4.

### (Bonding material arranging step S01)

First, a ceramic substrate 11 is prepared, and as shown in FIG. 4, Mg, Cu, an active metal (Ti, Zr, Nb, or Hf), and a transition metal (V, Cr, Mn, Fe, Co, Ni, Mo, Ta, or W) are arranged, as a bonding material 25, between the copper sheet 22, which is to be the circuit layer 12, and the ceramic substrate 11, and between the copper sheet 23, which is to be the metal layer 13, and the ceramic substrate 11.

Alternatively, as the bonding material 25, Ag, Cu, the active metal (Ti, Zr, Nb, or Hf), or the transition metal (V, Cr, Mn, Fe, Co, Ni, Mo, Ta, or W) are arranged.

In the bonding material arranging step S01, it is preferable to set the arranged amounts of Mg (or Ag), Cu, the active metal, and the transition metal are set as follows. In addition, Cu (or Ag or Cu) may not be arranged as long as the ceramic substrate 11 and the copper sheet 22 (copper sheet 23) can be bonded to each other.
Mg: 14.3 µmol/cm² or more and 71.5 µmol/cm² or less
Cu: 0 µmol/cm² or more and 70.5 µmol/cm² or less
Active metal: 0.8 µmol/cm² or more and 18.8 µmol/cm² or less
Transition metal: 1.0 µmol/cm² or more and 15.0 µmol/cm² or less or,
Ag: 0 µmol/cm² or more and 97.3 µmol/cm² or less
Cu: 0 µmol/cm² or more and 77.8 µmol/cm² or less
Active metal: 0.8 µmol/cm² or more and 18.8 µmol/cm² or less
Transition metal: 1.5 µmol/cm² or more and 15.0 µmol/cm² or less

### (Laminating step S02)

Next, the copper sheet 22 and the ceramic substrate 11 are laminated with the bonding material 25 (Mg (or Ag), Cu, the active metal, or the transition metal) interposed therebetween, and the ceramic substrate 11 and the copper sheet 23 are laminated with the bonding material 25 (Mg (or Ag), Cu, the active metal, or the transition metal) interposed therebetween.

### (Bonding step S03)

Next, the laminated copper sheet 22, the bonding material 25 (Mg (or Ag), Cu, the active metal, or the transition metal), the ceramic substrate 11, the bonding material 25 (Mg (or Ag), Cu, the active metal, or the transition metal), and the copper sheet 23 are pressurized in the lamination direction, are charged into a vacuum furnace, and are heated to bond the copper sheet 22, the ceramic substrate 11, and the copper sheet 23.

At this time, since each element of the bonding material 25 diffuses to the copper sheets 22 and 23 side or the ceramic substrate 11 side, and the Mg solid solution layer 36 and the active metal compound layer 31 are formed, there is no bonding layer between the ceramic substrate 11 and the circuit layer 12 (metal layer 13).

A heating temperature in the bonding step S03 is preferably set to be in a range of 750°C or higher and 950°C or lower, and a total of temperature integrated values in a temperature rising step from 740°C to the heating temperature and a holding step at the heating temperature is preferably set to be in a range of 30°C·h or more and 500°C·h or less.

A pressurization load P in the bonding step S03 is preferably set to be in a range of 0.098 MPa or more and 1.47 MPa or less.

In a case where Ag is arranged, the heating temperature in the bonding step S03 is preferably set to be in a range of 810°C or higher and 900°C or lower, and a total of temperature integrated values in a temperature rising step from 800°C to the heating temperature and a holding step at the heating temperature is preferably set to be in a range of 20°C·h or more and 5000°C·h or less.

In addition, in a case where Ag is not arranged, the heating temperature in the bonding step S03 is preferably set to be in a range of 900°C or higher and 1050°C or lower, and a total of temperature integrated values in a temperature rising step from 890°C to the heating temperature and a holding step at the heating temperature is preferably set to be in a range of 20°C·h or more and 5000°C·h or less.

As described above, the insulated circuit board 10 according to the present embodiment is manufactured by the bonding material arranging step S01, the laminating step S02, and the bonding step S03.

### (Heatsink bonding step S04)

Next, the heatsink 5 is bonded to the other surface side of the metal layer 13 of the insulated circuit board 10.

The insulated circuit board 10 and the heatsink 5 are laminated with a solder material being interposed therebetween and charged into a heating furnace, and the insulated circuit board 10 and the heatsink 5 are subjected to solder bonding with the solder layer 7 being interposed therebetween.

### (Semiconductor element-bonding step S05)

Next, the semiconductor element 3 is bonded by soldering to one surface of the circuit layer 12 of the insulated circuit board 10.

The power module 1 shown in FIG. 1 is produced by the above-described steps.

According to the insulated circuit board 10 (copper/ceramic bonded body) of the present embodiment having the above-described configuration, the active metal compound layer 31 is formed in the region of the ceramic substrate 11 on the circuit layer 12 (metal layer 13) side, and the transition metal layer 34 is formed in the interface of the active metal compound layer 31 on the circuit layer 12 (metal layer 13) side; and thereby, the bonding reliability between the ceramic substrate 11 and the circuit layer 12 (metal layer 13) is significantly improved.

In addition, in the insulated circuit board 10 of the present embodiment, in a case where the Mg solid solution layer 36 (or the Cu-Ag layer 36) is formed in the region of the circuit layer 12 (metal layer 13) on the ceramic substrate 11 side, and the transition metal layer 34 is formed between the Mg solid solution layer 36 (Cu phase and Ag phase) and the active metal compound layer 31, the bonding reliability between the ceramic substrate 11 and the circuit layer 12 (metal layer 13) is significantly improved.

### (Second embodiment)

A copper/ceramic bonded body according to a second embodiment of the present invention is an insulated circuit board 110 obtained by bonding a ceramic substrate 111 as a ceramic member consisting of ceramics and both of a copper sheet (a circuit layer 112) and a copper sheet (a metal layer 113) as a copper member consisting of copper or a copper alloy to each other.

In the present embodiment, the ceramic substrate 111 is composed of aluminum oxide (Al₂O₃) having excellent insulating properties and heat radiation.

In addition, a thickness of the ceramic substrate 111 is set to be, for example, in a range of 0.2 mm or more and 1.5 mm or less, and in the present embodiment, the thickness thereof is set to 0.635 mm.

The circuit layer 112 is formed by bonding the copper sheet consisting of copper or a copper alloy to one surface of the ceramic substrate 111.

In the present embodiment, the circuit layer 112 is formed by bonding a rolled sheet of oxygen-free copper to the ceramic substrate 111.

It is noted that a thickness of the copper sheet which is to be the circuit layer 112 is set in a range of 0.1 mm or more and 2.0 mm or less, and in the present embodiment, the thickness thereof is set to 0.25 mm.

The metal layer 113 is formed by bonding the copper sheet consisting of copper or a copper alloy to the other surface of the ceramic substrate 111.

In the present embodiment, the metal layer 113 is formed by bonding a rolled sheet of oxygen-free copper to the ceramic substrate 111.

It is noted that a thickness of the copper sheet which is to be the metal layer 113 is set to be in a range of 0.1 mm or more and 2.0 mm or less, and in the present embodiment, the thickness thereof is set to 0.25 mm.

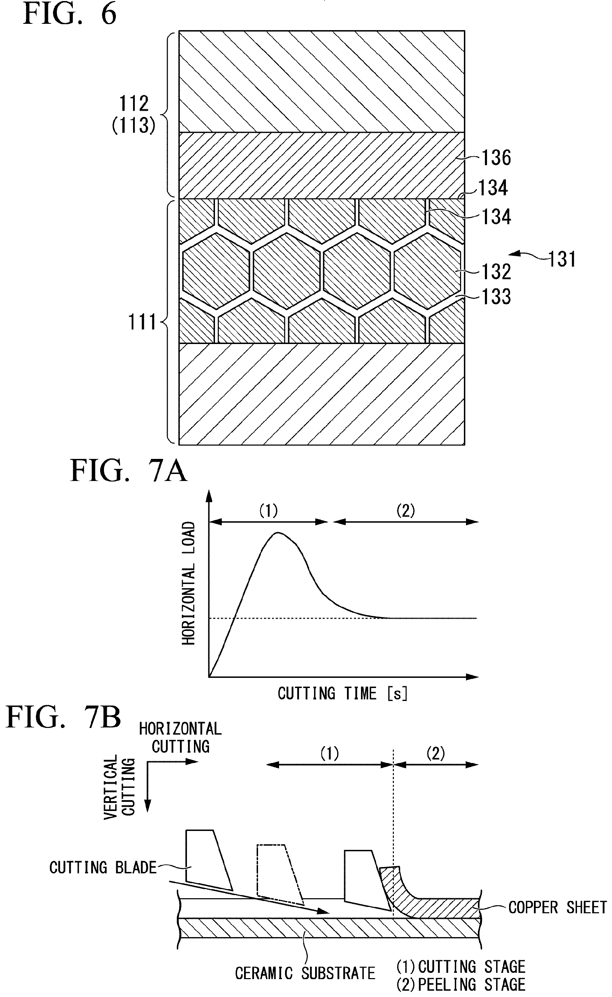

FIG. 6 shows an enlarged view of the vicinity of a bonded interface between the ceramic substrate 111 and the circuit layer 112 (metal layer 113).

A magnesium oxide layer 131 is formed in a region of the ceramic substrate 111 on the circuit layer 112 (metal layer 13) side.

The magnesium oxide layer 131 is formed by diffusing Mg used in a case of bonding the ceramic substrate 111 and the copper sheet to each other into the ceramic substrate 111 and reacting with oxygen of the ceramic substrate 111, and is a part of the ceramic substrate 111.

As shown in FIG. 6, the magnesium oxide layer 131 has a structure in which magnesium oxide particles 132 are aggregated, and a copper grain boundary phase 133 is present between the magnesium oxide particles 132.

In the present embodiment, the magnesium oxide particles 132 constituting the magnesium oxide layer 131 preferably have an average particle size in a range of 10 nm or more and 100 nm or less. In addition, the magnesium oxide particles 132 are composed of, for example, MgO or MgAl₂O₄.

A transition metal layer 134 containing one or more transition metals selected from the group consisting of V, Cr, Mn, Fe, Co, Ni, Mo, Ta, and W is formed in an interface of the magnesium oxide layer 131 on the circuit layer 112 (metal layer 113) side.

The transition metal layer 134 may be formed not only at the interface of the magnesium oxide layer 131 on the circuit layer 112 (metal layer 113) side, but also at the interface between the magnesium oxide particles 132 and the copper grain boundary phase 133. That is, the transition metal layer 134 may be formed on an outer peripheral surface of the magnesium oxide particles 132 constituting the magnesium oxide layer 131.

In addition, in the present embodiment, a Mg solid solution layer 136 is formed in a region of the circuit layer 112 (metal layer 113) on the ceramic substrate 111 side.

The Mg solid solution layer 136 is formed by diffusing Mg contained in a bonding material used in a case of bonding the ceramic substrate 111 and the copper sheet to the copper sheet side, and is a part of the circuit layer 112 (metal layer 113).

In the Mg solid solution layer 136, a Mg concentration is set to be in a range of 0.05 at% or more and 6.9 at% or less with respect to 100 at% of a total amount of Cu, Mg, the active metal, and the transition metal.

In addition, the Mg solid solution layer 136 may contain an intermetallic compound (for example, Cu₂Mg, CuMg₂, and the like) in which the Mg concentration is in a range of 30 at% or more and 70 at% or less.

In the present embodiment, a thickness of the magnesium oxide layer 131 is preferably set to be in a range of 0.05 µm or more and 1.2 µm or less.

In addition, in the present embodiment, a thickness of the Mg solid solution layer 136 is preferably set to be in a range of more than 0 µm and 200 µm or less, and more preferably set to be in a range of 50 µm or more and 120 µm or less.

Furthermore, in the present embodiment, a thickness of the transition metal layer 134 is preferably set to be in a range of 1 nm or more and 15 nm or less.

The insulated circuit board 110 of the second embodiment is manufactured by the manufacturing method shown in FIGS. 3 and 4, that is, the bonding material arranging step S01, the laminating step S02, and the bonding step S03, in the same manner as in the first embodiment.

According to the insulated circuit board 110 (copper/ceramic bonded body) of the present embodiment having the above-described configuration, the magnesium oxide layer 131 is formed in the region of the ceramic substrate 111 on the circuit layer 112 (metal layer 113) side, and the transition metal layer 134 is formed in the interface of the magnesium oxide layer 131 on the circuit layer 112 (metal layer 113) side; and thereby, the bonding reliability between the ceramic substrate 111 and the circuit layer 112 (metal layer 113) is significantly improved.

In addition, in the insulated circuit board 110 of the present embodiment, in a case where the Mg solid solution layer 136 is formed in the region of the circuit layer 112 (metal layer 113) on the ceramic substrate 111 side, and the transition metal layer 134 is formed between the Mg solid solution layer 136 and the magnesium oxide layer 131, the bonding reliability between the ceramic substrate 111 and the circuit layer 112 (metal layer 113) is significantly improved.

Hereinabove, the embodiment of the present invention has been described. However, the present invention is not limited thereto and can be suitably modified without departing from the technical features of the invention.

For example, the present embodiment has been described such that a semiconductor element is mounted on an insulated circuit board to constitute a power module; however, the present embodiment is not limited thereto. For example, an LED element may be mounted on a circuit layer of an insulated circuit board to constitute an LED module, or a thermoelectric element may be mounted on a circuit layer of an insulated circuit board to constitute a thermoelectric module.

In addition, in the insulated circuit board of the present embodiment, the ceramic substrate composed of aluminum nitride (AlN) and alumina (Al₂O₃) has been described as the example, but the present invention is not limited thereto, and other ceramic substrates such as silicon nitride (Si₃N₄) may be used.

Further, in the present embodiment, the circuit layer has been described as being formed by bonding a rolled sheet of oxygen-free copper to a ceramic substrate, but the present invention is not limited thereto, and the circuit layer may be formed by bonding a copper piece punched out from a copper sheet to a ceramic substrate in a circuit pattern state.

### Examples

### (Example 1)

Hereinafter, results of experiments for confirmation performed to confirm the effects of the present invention will be described.

First, ceramic substrates (40 mm × 40 mm) shown in Tables 1 to 3 were prepared. Thicknesses of AlN and Al₂O₃ were 0.635 mm, and a thickness of Si₃N₄ was 0.32 mm.

In addition, as a copper sheet which was to be the circuit layer and the metal layer, a copper sheet consisting of oxygen-free copper and having a thickness of 0.25 mm and a size of 37 mm × 37 mm was prepared.

Then, each element shown in Table 1 was arranged as a bonding material between the ceramic substrate and the copper sheet to obtain a laminate of copper sheet/ceramic substrate/copper sheet.

Next, a copper sheet and a ceramic substrate were bonded under the conditions shown in Tables 4 to 6 to obtain each of insulated circuit boards (copper/ceramic bonded bodies) of Invention Examples 1 to 8, 11 to 14, and 21 to 24 and Comparative Examples 1, 11, and 21.

The bonded interface of the obtained insulated circuit board (copper/ceramic bonded body) was observed.

In addition, the obtained insulated circuit board (copper/ceramic bonded body) was subjected to a thermal cycle in a liquid tank under conditions of -40°C × 5 min ←→ 150°C × 5 min up to 500 cycles. Thereafter, surface cutting was performed.

### (Observation of active metal compound layer)

An observation sample was collected from the obtained insulated circuit board (copper/ceramic bonded body), a cross section of the bonded interface between the copper sheet and the ceramic substrate was observed in a range of a height of 3 µm × a width of 4 µm at an acceleration voltage of 7 kV and a magnification of 30000 using an electron scanning microscope (Gemini SEM 500, manufactured by Carl Zeiss AG), a region where the active metal and nitrogen (N) coexisted was present, it was determined that a region where the concentration of the active metal was 20 at% or more with respect to a total amount of 100 at% of the active metal and nitrogen (N) in the region, was an active metal compound layer, and the area of the region was measured. The active metal compound layer was a part of the ceramic member. A thickness of the active metal compound layer was calculated by dividing the measured area by a measured visual field width. The measurement was carried out in five visual fields, and average value thereof was shown in Tables 4 to 6.

### (Observation of magnesium oxide layer)

An observation sample was collected from the obtained insulated circuit board (copper/ceramic bonded body), a cross section of the bonded interface between the copper sheet and the ceramic substrate was observed in a range of a height of 3 µm × a width of 4 µm at an acceleration voltage of 7 kV and a magnification of 30000 using an electron scanning microscope (Gemini SEM 500, manufactured by Carl Zeiss AG), a region where magnesium (Mg) and oxygen (O) coexisted was present, it was determined that a region where the concentration of magnesium (Mg) was 40 at% or more with respect to a total amount of 100 at% of magnesium (Mg) and oxygen (O) in the region, was a magnesium oxide layer, and the area of the region was measured. The magnesium oxide layer was a part of the ceramic member. A thickness of the active metal compound layer was calculated by dividing the measured area by a measured visual field width. The measurement was carried out in five visual fields, and average value thereof was shown in Tables 4 to 6.

### (Observation of Mg solid solution layer)

An observation sample was collected from the obtained insulated circuit board (copper/ceramic bonded body), a cross section of the bonded interface between the copper sheet and the ceramic substrate was subjected to line analysis in a range of a length of 200 µm in a direction of the copper member from the interface between the copper member and the active metal compound layer at an acceleration voltage of 15 kV using an EPMA device (JXA-8530F manufactured by JEOL, Ltd.), it was determined that a region where the concentration of Mg was 0.05 at% or more and 6.9 at% or less with respect to a total amount of 100 at% of the active metal, the transition metal, Mg, and Cu, was a Mg solid solution layer, and the measured length was set to a thickness of the Mg solid solution layer. The Mg solid solution layer was a part of the copper member. The measurement was carried out in five visual fields, and average value thereof was shown in Tables 4 to 6.

### (Observation of transition metal layer)

An observation sample was collected from the obtained insulated circuit board (copper/ceramic bonded body), a cross section of the bonded interface between the copper sheet and the ceramic substrate was observed in a range of a height of 50 nm × a width of 20 nm at an acceleration voltage of 200 kV and a magnification of 640000 using a scanning transmission electron microscope (Titan G2 ChemiSTEM manufactured by Thermo Fisher Scientific), it was determined that a region with the transition metal concentration higher than the transition metal concentration in the active metal compound layer (particles) by 1 at% or more with respect to a total amount of 100 at% of Cu, Mg, ceramic constituent elements, the active metal, and the transition metal, was the transition metal layer, and the area of the region was measured. A thickness of the transition metal layer was calculated by dividing the measured area by a measured visual field width. The measurement was carried out in five visual fields, and average value thereof was shown in Tables 4 to 6. The ceramic constituent elements were Al, Si, N, and O.

### (Surface cutting test)

The obtained insulated circuit board (copper/ceramic bonded body) was subjected to a thermal cycle in a liquid tank under conditions of -40°C × 5 min ←→ 150°C × 5 min up to 500 cycles.

A surface cutting test was performed on an insulated circuit board (copper/ceramic bonded body) on which a thermal cycle was loaded, and a bonding strength between the copper sheet and the ceramic substrate was evaluated.

In the surface cutting test, first, the copper sheet was cut to a thickness of 30 µm.

As shown in FIGS. 7A and 7B, a copper sheet was cut using a cutting blade having a blade width of 0.3 mm at a horizontal cutting speed of 2 µm/sec and a vertical cutting speed of 0.1 µm/sec ((1) cutting stage), the cutting blade was moved only in the horizontal direction at a time point when the cutting blade reached an interface between the copper sheet and the ceramic substrate ((2) peeling stage), and a horizontal load at a time point when the load in the horizontal direction was constant in the peeling stage was measured. The strength of the bonded interface was calculated by dividing the measured load by the blade width. The evaluation results are shown in Tables 4 to 6.

**[Table 1]**

| | | Ceramic substrate | Bonding material arranging step | | | | | | | | | | | | | | |
|---|---|---|---|---|---|---|---|---|---|---|---|---|---|---|---|---|---|
| | | | Amount of each element arranged (µmol/cm²) | | | | | | | | | | | | | | |
| | | | Cu | Mg | Active metal | | | | Transition metal | | | | | | | | |
| | | | | | Ti | Zr | Nb | Hf | V | Cr | Mn | Fe | Co | Ni | Mo | Ta | W |
| Invention Example | 1 | AIN | 14.1 | 57.2 | 0.9 | - | - | - | 1.2 | - | - | - | - | - | - | - | - |
| | 2 | AIN | 0.0 | 35.7 | 18.8 | - | - | - | 3.5 | - | - | - | - | - | - | - | - |
| | 3 | AIN | 42.3 | 42.9 | - | 2.9 | - | - | - | - | - | - | - | - | - | 1.8 | - |
| | 4 | AIN | 0.0 | 42.9 | - | - | 5.5 | - | - | - | - | 1.5 | - | - | - | - | - |
| | 5 | AIN | 0.0 | 42.9 | - | - | 8.3 | - | - | - | - | 15.0 | - | - | - | - | - |
| | 6 | AIN | 0.0 | 64.3 | - | - | - | 1.5 | - | - | - | - | - | - | - | 3.7 | - |
| | 7 | AIN | 70.5 | 7.1 | 2.8 | 10.0 | - | - | - | - | - | - | - | - | - | - | 4.2 |
| | 8 | AIN | 28.2 | 57.2 | 4.7 | - | 8.3 | - | - | - | - | 2.7 | - | 1.5 | - | - | - |
| Comparative Example | 1 | AIN | 0.0 | 28.6 | 14.1 | - | - | - | - | - | - | - | - | - | - | - | - |

**[Table 2]**

| | | Ceramic substrate | Bonding material arranging step | | | | | | | | | | | | | | |
|---|---|---|---|---|---|---|---|---|---|---|---|---|---|---|---|---|---|
| | | | Amount of each element arranged (µmol/cm²) | | | | | | | | | | | | | | |
| | | | Cu | Mg | Active metal | | | | Transition metal | | | | | | | | |
| | | | | | Ti | Zr | Nb | Hf | V | Cr | Mn | Fe | Co | Ni | Mo | Ta | W |
| Invention Example | 11 | Si₃N₄ | 28.2 | 7.1 | 0.9 | - | - | - | 11.8 | - | - | - | - | - | - | - | - |
| | 12 | Si₃N₄ | 0.0 | 35.7 | 4.7 | - | - | - | - | 1.4 | - | - | - | - | - | - | - |
| | 13 | Si₃N₄ | 0.0 | 35.7 | - | 2.9 | - | - | - | - | - | - | 1.6 | - | - | - | - |
| | 14 | Si₃N₄ | 0.0 | 28.6 | - | 7.1 | - | - | - | - | - | - | 6.4 | - | - | - | - |
| | 15 | Si₃N₄ | 0.0 | 35.7 | - | - | 9.2 | - | - | - | - | - | - | 7.6 | - | - | - |
| | 16 | Si₃N₄ | 56.4 | 71.5 | - | - | - | 1.1 | - | - | - | - | - | - | 1.1 | - | - |
| | 17 | Si₃N₄ | 42.3 | 64.3 | 14.1 | - | - | 3.0 | - | - | - | - | - | - | - | - | 5.2 |
| | 18 | Si₃N₄ | 70.5 | 35.7 | - | - | 12.0 | 1.1 | - | - | - | - | - | - | - | - | 2.1 |
| Comparative Example | 11 | Si₃N₄ | 28.2 | 14.3 | 9.4 | - | - | - | - | - | - | - | - | - | - | - | - |

**[Table 3]**

| | | Ceramic substrate | Bonding material arranging step | | | | | | | | | | | | | | |
|---|---|---|---|---|---|---|---|---|---|---|---|---|---|---|---|---|---|
| | | | Amount of each element arranged (µmol/cm²) | | | | | | | | | | | | | | |
| | | | Cu | Mg | Active metal | | | | Transition metal | | | | | | | | |
| | | | | | Ti | Zr | Nb | Hf | V | Cr | Mn | Fe | Co | Ni | Mo | Ta | W |
| Invention Example | 21 | Al₂O₃ | 14.1 | 28.6 | 14.1 | - | - | - | - | 9.7 | - | - | - | - | - | - | - |
| | 22 | Al₂O₃ | 42.3 | 35.7 | - | 8.6 | - | - | - | - | 13.1 | - | - | - | - | - | - |
| | 23 | Al₂O₃ | 14.1 | 50.0 | - | - | 12.0 | - | - | - | - | - | 12.7 | - | - | - | - |
| | 24 | Al₂O₃ | 0.0 | 64.3 | - | - | - | 6.0 | - | - | 1.0 | - | - | - | 0.3 | - | - |
| Comparative Example | 21 | Al₂O₃ | 0.0 | 21.4 | 14.1 | - | - | - | - | - | - | - | - | - | - | - | - |

**[Table 4]**

| | | Bonding step | | | Evaluation | | | | |
|---|---|---|---|---|---|---|---|---|---|
| | | Heating temperature °C | Temperature integrated values °C·h | Pressurization load MPa | Bonded interface observation | | | | Strength of bonded interface N/mm |
| | | | | | Active metal compound layer µm | Magnesium oxide layer µm | Mg solid solution layer µm | Transition metal layer nm | |
| Invention Example | 1 | 950 | 494 | 1.47 | 0.07 | - | 115.6 | 2.3 | 14.3 |
| | 2 | 800 | 55 | 0.784 | 1.04 | - | 55.1 | 5.9 | 12.6 |
| | 3 | 900 | 341 | 1.47 | 0.22 | - | 103.2 | 4.2 | 14.6 |
| | 4 | 750 | 10 | 0.98 | 0.26 | - | 50.3 | 1.3 | 6.5 |
| | 5 | 750 | 15 | 0.098 | 0.47 | - | 56.2 | 4.5 | 16.8 |
| | 6 | 950 | 280 | 0.784 | 0.14 | - | 89.9 | 5.0 | 15.6 |
| | 7 | 950 | 340 | 1.47 | 1.18 | - | 104.5 | 2.6 | 14.7 |
| | 8 | 900 | 70 | 0.784 | 1.13 | - | 53.1 | 3.0 | 14.1 |
| Comparative Example | 1 | 900 | 363 | 0.098 | 1.16 | - | 87.2 | - | 3.3 |

**[Table 5]**

| | | Bonding step | | | Evaluation | | | | |
|---|---|---|---|---|---|---|---|---|---|
| | | Heating temperature °C | Temperature integrated values °C·h | Pressurization load MPa | Bonded interface observation | | | | Strength of bonded interface N/mm |
| | | | | | Active metal compound layer µm | Magnesium oxide layer µm | Mg solid solution layer µm | Transition metal layer nm | |
| Invention Example | 11 | 750 | 20 | 1.47 | 0.05 | - | 59.6 | 4.1 | 15.0 |
| | 12 | 850 | 93 | 0.98 | 0.23 | - | 63.8 | 1.2 | 8.1 |
| | 13 | 850 | 227 | 0.098 | 0.34 | - | 73.1 | 1.5 | 7.4 |
| | 14 | 800 | 17 | 0.294 | 0.69 | - | 50.0 | 5.2 | 12.9 |
| | 15 | 900 | 110 | 0.294 | 0.82 | - | 63.5 | 10.9 | 9.9 |
| | 16 | 900 | 110 | 0.098 | 0.09 | - | 68.2 | 1.3 | 7.5 |
| | 17 | 900 | 163 | 0.294 | 1.17 | - | 67.1 | 9.8 | 8.6 |
| | 18 | 750 | 20 | 0.784 | 1.05 | - | 57.9 | 3.9 | 16.4 |
| Comparative Example | 11 | 850 | 62 | 1.47 | 0.78 | - | 63.6 | - | 2.4 |

**[Table 6]**

| | | Bonding step | | | Evaluation | | | | |
|---|---|---|---|---|---|---|---|---|---|
| | | Heating temperature °C | Temperature integrated values °C·h | Pressurization load MPa | Bonded interface observation | | | | Strength of bonded interface N/mm |
| | | | | | Active metal compound layer µm | Magnesium oxide layer µm | Mg solid solution layer µm | Transition metal layer nm | |
| Invention Example | 21 | 850 | 59 | 1.47 | - | 0.66 | 73.9 | 8.5 | 10.0 |
| | 22 | 900 | 254 | 0.98 | - | 1.17 | 85.7 | 14.8 | 7.6 |
| | 23 | 850 | 234 | 1.47 | - | 1.14 | 73.1 | 2.7 | 5.5 |
| | 24 | 850 | 117 | 0.098 | - | 0.89 | 63.4 | 1.4 | 4.8 |
| Comparative Example | 21 | 900 | 523 | 1.47 | - | 0.13 | 45.0 | - | 3.9 |

In a case of comparing Invention Examples 1 to 8 and Comparative Example 1 in which the ceramic substrate was composed of AlN, it was confirmed that, in Invention Examples 1 to 8 in which the transition metal layer was formed, the strength of the bonded interface was improved as compared to Comparative Example 1 in which the transition metal layer was not formed.

In a case of comparing Invention Examples 11 to 18 and Comparative Example 11 of the present invention in which the ceramic substrate was composed of Si₃N₄, it was confirmed that, in Invention Examples 11 to 18 in which the transition metal layer was formed, the strength of the bonded interface was improved as compared to Comparative Example 11 in which the transition metal layer was not formed.

In a case of comparing Invention Examples 21 to 24 and Comparative Example 21 in which the ceramic substrate was composed of Al₂O₃, it was confirmed that, in Invention Examples 21 to 24 in which the transition metal layer was formed, the strength of the bonded interface was improved as compared to Comparative Example 21 in which the transition metal layer was not formed.

From the results of the confirmation experiments described above, according to Invention Examples, it was confirmed that it is possible to provide an insulated circuit board (copper/ceramic bonded body) having an excellent bonding rate between a ceramic member and a copper member and excellent thermal cycle reliability, even in a case where a severe thermal cycle is loaded.

### (Example 2)

First, a ceramic substrate (40 mm × 40 mm) shown in Table 7 was prepared. Thicknesses of AlN and Al₂O₃ were 0.635 mm, and a thickness of Si₃N₄ was 0.32 mm.

In addition, as a copper sheet which was to be the circuit layer and the metal layer, a copper sheet consisting of oxygen-free copper and having a thickness of 0.25 mm and a size of 37 mm × 37 mm was prepared.

Then, each element shown in Table 7 was arranged as a bonding material between the ceramic substrate and the copper sheet to obtain a laminate of copper sheet/ceramic substrate/copper sheet.

Next, a copper sheet and a ceramic substrate were bonded under the conditions shown in Table 8 to obtain each of insulated circuit boards (copper/ceramic bonded bodies) of Invention Examples A1 to A16 and Comparative Examples A1 to A3.

The bonded interface of the obtained insulated circuit board (copper/ceramic bonded body) was observed, and the surface cutting test was performed.

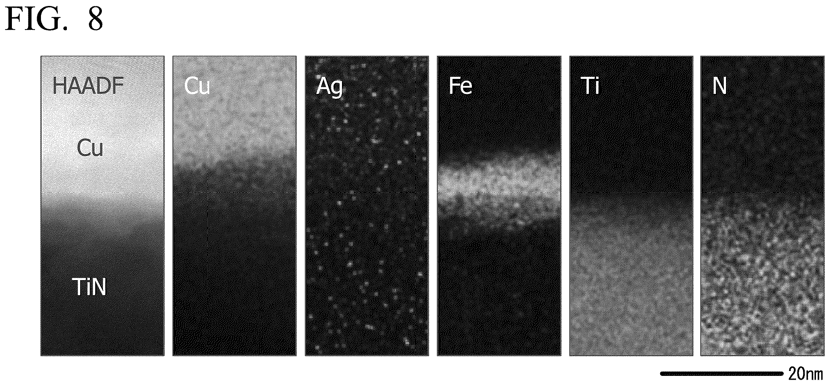

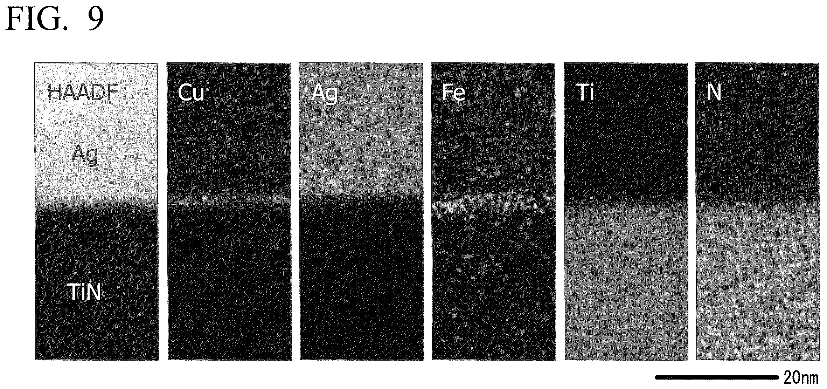

The observation of each layer at the bonded interface was carried out as follows. FIG. 8 shows the observation results of Invention Example A1, and FIG. 9 shows the observation results of Invention Example A2.

### (Observation of active metal compound layer)

The active metal compound layer was observed basically by the same method as in Example 1. In Example 2, a region where the active metal and N or O coexisted was present, it was determined that a region where the concentration of the active metal was 20 at% or more with respect to a total amount of 100 at% of the active metal, N, and O in the region, was the active metal compound layer, and the area of the region was measured. The thickness of the active metal compound layer was calculated by the same method as in Example 1.

The measurement was carried out in five visual fields, and average value thereof was shown in Table 8.

### (Observation of Cu-Ag layer)

An observation sample was collected from the obtained insulated circuit board (copper/ceramic bonded body), a cross section of the bonded interface between the copper sheet and the ceramic substrate was subjected to line analysis in a range of a length of 100 µm in a direction of the copper member from the interface between the copper member and the active metal compound layer at an acceleration voltage of 15 kV using an EPMA device (JXA-8530F manufactured by JEOL, Ltd.), it was determined that a region where the concentration of Ag was 9 at% or more with respect to a total amount of 100 at% of the active metal, Ag, and Cu, was a Cu-Ag layer, and the measured length was set to a thickness of the Cu-Ag layer. The Cu-Ag layer was a part of the copper member. The measurement was carried out in five visual fields, and average value thereof was shown in Table 8.

The Cu phase in the Cu-Ag layer was integrated with Cu of the copper sheet, and thus could not be distinguished in terms of composition.

### (Observation of transition metal layer)

The transition metal layer was observed basically by the same method as in Example 1. In Example 2, it was determined that a region with the transition metal concentration higher than the transition metal concentration in the active metal compound layer (particles) by 1 at% or more with respect to a total amount of 100 at% of Cu, Ag, ceramic constituent elements, the active metal, and the transition metal, was the transition metal layer, and the area of the region was measured. A thickness of the transition metal layer was calculated by dividing the measured area by a measured visual field width. The measurement was carried out in five visual fields, and average value thereof was shown in Table 8. The ceramic constituent elements were Al, Si, N, and O.

FIG. 8 shows the observation results of Invention Example A1, and FIG. 9 shows the observation results of Invention Example A2.

### (Surface cutting test)

The surface cutting test was performed in the same manner as in Example 1. The evaluation results are shown in Table 8.

**[Table 7]**

| | | Ceramic substrate | Bonding material arranging step | | | | | | | | | | | |
|---|---|---|---|---|---|---|---|---|---|---|---|---|---|---|
| | | | Amount of each element arranged (µmol/cm²) | | | | | | | | | | | |
| | | | Cu | Ag | Active metal | | | | Transition metal | | | | | |
| | | | | | Ti | Zr | Nb | Hf | V | Cr | Mn | Fe | Co | Ni |
| Invention Example | A1 | AIN | 77.8 | 0.0 | 9.4 | - | - | - | - | - | - | 9.9 | - | - |
| | A2 | AIN | 26.7 | 73.2 | 4.7 | - | - | - | - | - | - | 2.1 | - | - |
| | A3 | AIN | 0.0 | 0.0 | - | 7.1 | - | - | - | - | 2.7 | - | - | - |
| | A4 | AIN | 0.0 | 97.3 | - | - | 9.2 | - | 1.5 | - | - | - | - | - |
| | A5 | AIN | 26.7 | 61.9 | - | - | - | 7.5 | - | 5.5 | - | - | - | 2.3 |
| | A6 | AIN | 51.3 | 0.0 | 4.7 | 3.5 | - | - | - | - | - | - | 3.0 | - |
| | A7 | AIN | 0.0 | 39.3 | - | 0.8 | - | - | - | - | - | - | - | 10.6 |
| | A8 | Si₃N₄ | 26.7 | 39.3 | 3.1 | - | - | - | - | 2.8 | - | - | - | 3.0 |
| | A9 | Si₃N₄ | 26.7 | 73.2 | - | 14.2 | - | - | - | - | - | 3.5 | - | - |
| | A10 | Si₃N₄ | 0.0 | 0.0 | - | - | - | 6.0 | 7.2 | - | - | - | - | - |
| | A11 | Si₃N₄ | 77.8 | 21.1 | - | - | 18.8 | - | - | - | - | - | 1.5 | - |
| | A12 | Si₃N₄ | 0.0 | 21.2 | 1.8 | - | 4.6 | - | - | - | - | - | - | 7.6 |
| | A13 | Si₃N₄ | 0.0 | 61.9 | - | 4.2 | - | 1.5 | - | 12.5 | - | - | - | - |
| | A14 | Si₃N₄ | 0.0 | 61.9 | - | - | - | 0.8 | - | - | 15.0 | - | - | - |
| | A15 | Al₂O₃ | 0.0 | 21.2 | 7.5 | - | - | - | 3.6 | - | - | 4.2 | - | - |
| | A16 | Al₂O₃ | 26.7 | 73.2 | - | 10.7 | - | - | - | - | - | - | - | 4.5 |
| Comparative Example | A1 | AIN | 0.0 | 39.3 | 9.4 | - | - | - | - | - | - | - | - | - |
| | A2 | Si₃N₄ | 0.0 | 39.3 | 3.1 | - | - | - | - | - | - | - | - | - |
| | A3 | Al₂O₃ | 0.0 | 39.3 | 7.5 | - | - | - | - | - | - | - | - | - |

**[Table 8]**

| | | Bonding step | | | Evaluation | | | |
|---|---|---|---|---|---|---|---|---|
| | | Heating temperature °C | Temperature integrated values °C·h | Pressurization load MPa | Bonded interface observation | | | Strength of bonded interface N/mm |
| | | | | | Active metal compound layer µm | Cu-Ag layer µm | Transition metal layer nm | |
| Invention Example | A1 | 970 | 4108 | 1.47 | 0.39 | - | 12.7 | 2.73 |
| | A2 | 830 | 788 | 0.98 | 0.78 | 10.3 | 3.5 | 2.56 |
| | A3 | 900 | 29 | 0.294 | 0.78 | - | 1.8 | 2.44 |
| | A4 | 810 | 21 | 0.98 | 0.77 | 12.7 | 1.2 | 2.42 |
| | A5 | 850 | 417 | 1.47 | 0.79 | 9.1 | 1.5 | 2.41 |
| | A6 | 1000 | 2725 | 0.294 | 0.80 | - | 1.7 | 2.47 |
| | A7 | 900 | 1253 | 0.294 | 0.08 | 5.8 | 1.7 | 2.44 |
| | A8 | 830 | 231 | 0.98 | 0.18 | 5.1 | 1.8 | 2.45 |
| | A9 | 830 | 176 | 0.294 | 1.17 | 11.3 | 1.7 | 2.46 |
| | A10 | 1050 | 4875 | 1.47 | 0.47 | - | 7.9 | 2.71 |
| | A11 | 850 | 120 | 0.98 | 1.20 | 2.9 | 1.0 | 2.40 |
| | A12 | 830 | 158 | 0.098 | 0.41 | 3.0 | 5.9 | 2.64 |
| | A13 | 830 | 142 | 0.49 | 0.46 | 9.6 | 9.8 | 2.69 |
| | A14 | 810 | 20 | 0.294 | 0.05 | 8.6 | 14.9 | 2.76 |
| | A15 | 850 | 554 | 0.294 | 0.55 | 2.9 | 2.3 | 2.27 |
| | A16 | 810 | 23 | 1.47 | 1.05 | 10.4 | 2.2 | 2.32 |
| Comparative Example | A1 | 830 | 156 | 0.49 | 0.78 | 5.8 | - | 2.24 |
| | A2 | 830 | 156 | 0.49 | 0.17 | 5.9 | - | 2.38 |
| | A3 | 830 | 156 | 0.49 | 0.55 | 5.6 | - | 2.12 |

In a case of comparing Invention Examples A1 to A7 and Comparative Example A1 in which the ceramic substrate was composed of AlN, it was confirmed that, in Invention Examples A1 to A7 in which the transition metal layer was formed, the strength of the bonded interface was improved as compared to Comparative Example A1 in which the transition metal layer was not formed.

In a case of comparing Invention Examples A8 to A14 and Comparative Example A2 in which the ceramic substrate was composed of Si₃N₄, it was confirmed that, in Invention Examples A8 to A14 in which the transition metal layer was formed, the strength of the bonded interface was improved as compared to Comparative Example A2 in which the transition metal layer was not formed.

In a case of comparing Invention Examples A15 and A16 and Comparative Example A3 in which the ceramic substrate was composed of Al₂O₃, it was confirmed that, in Invention Examples A15 and A16 in which the transition metal layer was formed, the strength of the bonded interface was improved as compared to Comparative Example A3 in which the transition metal layer was not formed.

In Invention Example A1, as shown in FIG. 8, it was observed that a Fe phase (transition metal layer) was formed between the Cu phase and the TiN (active metal compound layer).

In addition, in Invention Example A2, as shown in FIG. 9, it was observed that a Fe phase (transition metal layer) was formed between the Ag phase and the TiN (active metal compound layer). In addition, in FIG. 9, the Cu phase was confirmed between the Ag phase and the Fe phase (transition metal layer).

### (Example 3)

In the same manner as in Example 2 described above, a ceramic substrate (40 mm × 40 mm) shown in Table 9 was prepared. Thicknesses of AlN and Al₂O₃ were 0.635 mm, and a thickness of Si₃N₄ was 0.32 mm.

In addition, as a copper sheet which was to be the circuit layer and the metal layer, a copper sheet consisting of oxygen-free copper and having a thickness of 0.25 mm and a size of 37 mm × 37 mm was prepared.

Then, each element shown in Table 9 was arranged as a bonding material between the ceramic substrate and the copper sheet to obtain a laminate of copper sheet/ceramic substrate/copper sheet.

Next, a copper sheet and a ceramic substrate were bonded under the conditions shown in Table 10 to obtain each of insulated circuit boards (copper/ceramic bonded bodies) of Invention Examples A21 to A30 and Comparative Examples A21 to A23.

The bonded interface of the obtained insulated circuit board (copper/ceramic bonded body) was observed in the same manner as in Example 2. The evaluation results are shown in Table 10.

In addition, the obtained insulated circuit board (copper/ceramic bonded body) was subjected to a thermal cycle in a liquid tank under conditions of -40°C × 5 min ←→ 150°C × 5 min up to 1000 cycles. Thereafter, the surface cutting test was performed in the same manner as in Example 2. The evaluation results are shown in Table 10.

**[Table 9]**

| | | Ceramic substrate | Bonding material arranging step | | | | | | | | | | | | | | |
|---|---|---|---|---|---|---|---|---|---|---|---|---|---|---|---|---|---|
| | | | Amount of each element arranged (µmol/cm²) | | | | | | | | | | | | | | |
| | | | Cu | Ag | Active metal | | | | Transition metal | | | | | | | | |
| | | | | | Ti | Zr | Nb | Hf | V | Cr | Mn | Fe | Co | Ni | Mo | Ta | W |
| Invention Example | A21 | AIN | 26.7 | 73.2 | 4.7 | - | - | - | - | - | - | 2.1 | - | - | - | - | - |
| | A22 | AIN | 26.7 | 73.2 | 4.7 | - | - | - | - | - | - | 2.1 | - | - | - | - | 1.1 |
| | A23 | AIN | 0.0 | 0.0 | - | 7.1 | - | - | - | - | 2.7 | - | - | - | - | - | - |
| | A24 | AIN | 0.0 | 0.0 | - | 7.1 | - | - | - | - | - | - | - | - | 3.8 | - | - |
| | A25 | Si₃N₄ | 26.7 | 73.2 | - | 14.2 | - | - | - | - | - | 3.5 | - | - | - | - | - |
| | A26 | Si₃N₄ | 26.7 | 73.2 | - | - | 6.4 | - | - | - | - | - | - | - | - | 2.4 | - |
| | A27 | Si₃N₄ | 51.3 | 0.0 | 4.7 | 3.5 | - | - | 15.0 | - | - | - | - | - | - | - | - |
| | A28 | Si₃N₄ | 51.3 | 0.0 | 4.7 | 3.5 | - | - | - | 9.8 | - | - | 2.2 | - | - | - | - |
| | A29 | Al₂O₃ | 26.7 | 73.2 | - | 10.7 | - | - | - | - | - | - | - | 4.5 | - | - | - |
| | A30 | Al₂O₃ | 26.7 | 73.2 | - | - | - | 7.9 | - | - | - | - | - | 2.3 | - | 2.9 | - |
| Comparative Example | A21 | AIN | 26.7 | 73.2 | 4.7 | - | - | - | - | - | - | - | - | - | - | - | - |
| | A22 | Si₃N₄ | 26.7 | 73.2 | 4.7 | - | - | - | - | - | - | - | - | - | - | - | - |
| | A23 | Al₂O₃ | 26.7 | 73.2 | 4.7 | - | - | - | - | - | - | - | - | - | - | - | - |

**[Table 10]**

| | | Bonding step | | | Evaluation | | | |
|---|---|---|---|---|---|---|---|---|
| | | Heating temperature °C | Temperature integrated values °C·h | Pressurization load MPa | Bonded interface observation | | | Strength of bonded interface after thermal cycle N/mm |
| | | | | | Active metal compound layer µm | Cu-Ag layer µm | Transition metal layer nm | |
| Invention Example | A21 | 830 | 788 | 0.98 | 0.78 | 10.3 | 3.5 | 2.55 |
| | A22 | 830 | 788 | 0.98 | 0.55 | 10.7 | 5.3 | 2.61 |
| | A23 | 900 | 29 | 0.294 | 0.78 | - | 1.8 | 2.43 |
| | A24 | 900 | 29 | 0.294 | 0.84 | - | 2.3 | 2.34 |
| | A25 | 830 | 176 | 0.294 | 1.17 | 11.3 | 1.7 | 2.44 |
| | A26 | 830 | 176 | 0.49 | 0.58 | 11.0 | 2.1 | 2.39 |
| | A27 | 1000 | 2725 | 0.294 | 0.82 | - | 14.6 | 2.70 |
| | A28 | 1000 | 2725 | 0.294 | 0.87 | - | 13.3 | 2.68 |
| | A29 | 810 | 23 | 1.47 | 1.05 | 10.4 | 2.2 | 2.32 |
| | A30 | 810 | 23 | 1.47 | 0.85 | 10.7 | 3.7 | 2.45 |
| Comparative Example | A21 | 830 | 511 | 0.49 | 0.88 | 9.4 | - | 2.02 |
| | A22 | 830 | 511 | 0.49 | 0.74 | 9.8 | - | 2.08 |
| | A23 | 830 | 511 | 0.49 | 0.81 | 9.7 | - | 1.95 |

In a case of comparing Invention Examples A21 to A24 and Comparative Example A21 in which the ceramic substrate was composed of AlN, it was confirmed that, in Invention Examples A21 to A24 in which the transition metal layer was formed, the strength of the bonded interface after the thermal cycle load was improved as compared to Comparative Example A21 in which the transition metal layer was not formed.

In a case of comparing Invention Examples A25 to A28 and Comparative Example A22 in which the ceramic substrate was composed of Si₃N₄, it was confirmed that, in Invention Examples A25 to A28 in which the transition metal layer was formed, the strength of the bonded interface after the thermal cycle load was improved as compared to Comparative Example A22 in which the transition metal layer was not formed.

In a case of comparing Invention Examples A29 and A30 and Comparative Example A23 in which the ceramic substrate was composed of Al₂O₃, it was confirmed that, in Invention Examples A29 and A30 in which the transition metal layer was formed, the strength of the bonded interface after the thermal cycle load was improved as compared to Comparative Example A23 in which the transition metal layer was not formed.

From the results of the confirmation experiments described above, according to Invention Examples, it was confirmed that it is possible to provide an insulated circuit board (copper/ceramic bonded body) having an excellent bonding rate between a ceramic member and a copper member and excellent thermal cycle reliability, even in a case where a severe thermal cycle is loaded.

### INDUSTRIAL APPLICABILITY

It is possible to provide a copper/ceramic bonded body having an excellent bonding rate between a ceramic member and a copper member and excellent thermal cycle reliability, even in a case where a severe thermal cycle is loaded, and an insulated circuit board consisting of the copper/ceramic bonded body.

### REFERENCE SIGNS LIST

10, 110 insulated circuit board (copper/ceramic bonded body)
11, 111 Ceramic substrate (ceramic member)
12, 112 Circuit layer (copper member)
13, 113 Metal layer (copper member)
31 active metal compound layer
34, 134 transition metal layer
36, 136 Mg solid solution layer (or Cu-Ag layer)
131 magnesium oxide layer

## Claims

1. A copper/ceramic bonded body in which a copper member consisting of copper or a copper alloy and a ceramic member are bonded to each other,
wherein an active metal compound layer containing a compound of one or more active metals selected from the group consisting of Ti, Zr, Nb, and Hf, or a magnesium oxide layer is formed in a region of the ceramic member on a copper member side, and
a transition metal layer containing one or more transition metals selected from the group consisting of V, Cr, Mn, Fe, Co, Ni, Mo, Ta, and W is formed in an interface of the active metal compound layer or the magnesium oxide layer on the copper member side.

2. The copper/ceramic bonded body according to Claim 1,
wherein a Mg solid solution layer is formed in a region of the copper member on a ceramic member side, and
the transition metal layer is formed between the Mg solid solution layer and either one of the active metal compound layer or the magnesium oxide layer.

3. The copper/ceramic bonded body according to Claim 2,
wherein the active metal compound layer has a structure in which a plurality of active metal compound particles are aggregated.

4. The copper/ceramic bonded body according to Claim 3,
wherein a copper grain boundary phase is present between the active metal compound particles.

5. The copper/ceramic bonded body according to Claim 2,
wherein the magnesium oxide layer has a structure in which a plurality of magnesium oxide particles are aggregated.

6. The copper/ceramic bonded body according to Claim 5,
wherein a copper grain boundary phase is present between the magnesium oxide particles.

7. An insulated circuit board in which a copper sheet consisting of copper or a copper alloy is bonded to a surface of a ceramic substrate,
wherein an active metal compound layer containing a compound of one or more active metals selected from the group consisting of Ti, Zr, Nb, and Hf, or a magnesium oxide layer is formed in a region of the ceramic substrate on a copper sheet side, and
a transition metal layer containing one or more transition metals selected from the group consisting of V, Cr, Mn, Fe, Co, Ni, Mo, Ta, and W is formed in an interface of the active metal compound layer or the magnesium oxide layer on the copper sheet side.

8. The insulated circuit board according to Claim 7,
wherein a Mg solid solution layer is formed in a region of the copper sheet on a ceramic substrate side, and
the transition metal layer is formed between the Mg solid solution layer and either one of the active metal compound layer or the magnesium oxide layer.

9. The insulated circuit board according to Claim 8,
wherein the active metal compound layer has a structure in which a plurality of active metal compound particles are aggregated.

10. The insulated circuit board according to Claim 9,
wherein a copper grain boundary phase is present between the active metal compound particles.

11. The insulated circuit board according to Claim 8,
wherein the magnesium oxide layer has a structure in which a plurality of magnesium oxide particles are aggregated.

12. The insulated circuit board according to Claim 11,
wherein a copper grain boundary phase is present between the magnesium oxide particles.

13. The copper/ceramic bonded body according to Claim 1,
wherein the active metal compound layer is formed in a region of the ceramic member on the copper member side, among the active metal compound layer and the magnesium oxide layer.

14. The insulated circuit board according to Claim 7,
wherein the active metal compound layer is formed in a region of the ceramic substrate on the copper sheet side, among the active metal compound layer and the magnesium oxide layer.
